# EUROPEAN PATENT APPLICATION

(11) **EP 2 482 455 A2**
(43) Date of publication of application: **01.08.2012**
(21) Application number: 12152618.0
(22) Date of filing: 26.01.2012
(51) Int. Cl.: H03K 5/19

(54) **Oscillation-stop detection circuit, semiconductor device, timepiece, and electronic device**

(30) Priority: 28.01.2011 JP 2011016984
(71) Applicant: Seiko Epson Corporation, Shinjuku-ku Tokyo 163-0811 (JP)
(72) Inventor: Nakamiya, Shinji, Nagano, 392-8502 (JP)
(74) Representative: HOFFMANN EITLE

(57) **Abstract**

An oscillation-stop detection circuit can be manufactured at low cost without requiring controlling difficult manufacturing process conditions. Inverter 30 outputs an oscillation state detection signal. N-channel transistor 26 is a transistor that discharges capacitor 20. A reference voltage generator 21 includes a depletion-mode P-channel transistor 22 of which the gate and source are connected together, and a N-channel transistor 23 of which the gate and drain are connected together, N-channel transistor 23 and N-channel transistor 26 rendering a current mirror.

## Description

### BACKGROUND

### 1. Technical Field

The present invention relates to oscillation-stop detection circuit that detects when an oscillation circuit stops oscillating, to a semiconductor device having this oscillation-stop detection circuit, to a timepiece, and to an electronic device.

### 2. Related Art

Timepieces and other electronic devices with an internal oscillation circuit commonly lower the power supply voltage from the regulator to the oscillation circuit when the oscillation circuit is oscillating normally to reduce power consumption, and in order to avoid unstable operation when the oscillation circuit stops oscillating, reset the system and boost the drive voltage supplied to the oscillation circuit to start the oscillation circuit oscillating again. Such electronic devices have an oscillation-stop detection circuit that detects when the oscillation circuit stops oscillating to enable this type of control. This type of oscillation-stop detection circuit is taught, for example, in Japanese Unexamined Patent Appl. Pub. JP-A-2007-81514 and Japan Patent No. 4459663.

The oscillation-stop detection circuit taught in JP-A-2007-81514 has a capacitor, a switching means that switches and relays a charge to a capacitor according to a control signal generated from the output signal from an oscillation circuit, a resistance for discharging charge stored in the capacitor, and an oscillation state detection means that determines the oscillation state of the oscillation circuit based on whether the capacitor charge is greater than or equal to a reference level. The switching means is a MOSFET (metal oxide semiconductor field effect transistor, referred to below as simply a transistor). Because a control signal of a specific frequency is applied to the switching means when the oscillation circuit is oscillating normally in this configuration, charge current exceeding the discharge current of the discharge resistor is supplied through the switching means to the capacitor. As a result, the charge voltage of the capacitor exceeds the reference level, and an oscillation state detection signal indicating that the oscillation circuit is oscillating is obtained from the oscillation state detection means. However, when the oscillation circuit stops oscillating, the control signal of a specific frequency is not applied to the switching means, supply of charge current to the capacitor stops, the capacitor charge voltage drops below the reference level, and an oscillation state detection signal indicating that oscillation stopped is obtained from the oscillation state detection means.

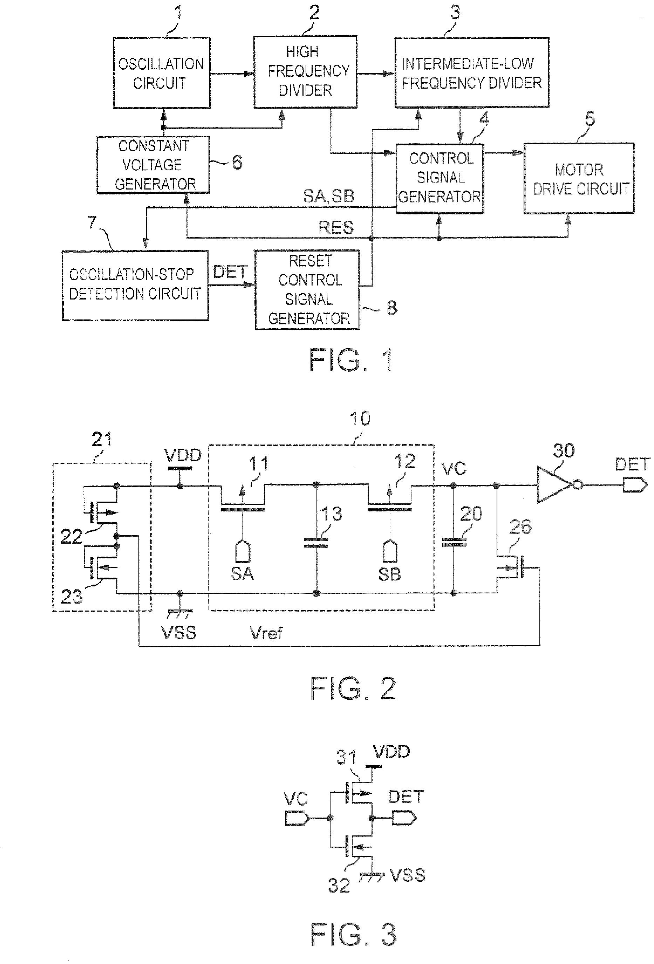

The oscillation-stop detection circuit described in Japan Patent No. 4459663 uses a transistor as the discharge device for discharging the charge stored in the capacitor. The reference voltage VREF output by the regulator that generates the supply voltage to the oscillation circuit is applied to the gate of the transistor, and the transistor functions as a constant current source (FIG. 3).

In order for the above oscillation-stop detection circuits to correctly detect the oscillation state of the oscillation circuit, a suitable balance must be maintained between the OFF current flowing through the switching means to the capacitor when the switching means is not switching, the ON current flowing through the switching means to the capacitor when the switching means is switching, and the discharge current flowing out from the capacitor through the discharge device. However, this current balance is easily disrupted with the technology taught in JP-A-2007-81514 and Japan Patent No. 4459663 due to the manufacturing tolerances of the transistors and resistors, and the effects of change in ambient temperature. Strict process control is therefore required to minimize the manufacturing tolerances of the transistors and resistors in order to obtain oscillation-stop detection circuits with the expected performance, and low-cost production of oscillation-stop detection circuits is difficult.

### SUMMARY

An object of the present invention is to provide an oscillation-stop detection circuit that can be produced at low cost with the expected performance without requiring difficult process control, a semiconductor device having the oscillation-stop detection circuit, a timepiece, and an electronic device.

One aspect of the invention is an oscillation-stop detection circuit including: a switching field-effect transistor (FET) that passes a charge by switching according to a control signal generated from an output signal of an oscillation circuit; a capacitor that is charged by charge passed from the switching FET; a discharge means that discharges capacitor charge; and an oscillation state detection means that digitizes the charge voltage of the capacitor and outputs an oscillation state detection signal that indicates if the oscillation circuit is oscillating or is stopped; wherein the discharge means includes a discharge FET that discharges charge stored in the capacitor, a mirror FET that with the discharge FET renders a current mirror, and a constant current source composed of a field-effect transistor that is the same conductive type as the switching FET, and supplies drain current to a common coupling node of the gate and drain of the mirror FET.

A discharge current proportional to the output current of the constant current source flows to the discharge FET in this oscillation-stop detection circuit. The constant current source is rendered by a FET of the same conductive type as the switching FET. As a result, when the OFF current supplied to the capacitor through the switching FET in the OFF state, or the ON current supplied to the capacitor through the switching FET in the ON state, increases (decreases) due to manufacturing tolerances or change in the ambient temperature or other operating condition, the discharge current flowing from the capacitor through the discharge FET also increases (decreases). The balance between the OFF current and ON current flowing through the switching FET and the discharge current of the discharge FET in the oscillation-stop detection circuit according to this aspect of the invention is therefore not easily affected by manufacturing tolerances or change in operating conditions. Controlling the conditions of difficult production processes is therefore not necessary, and an oscillation-stop detection circuit with the expected performance can be manufactured at low cost.

In another aspect of the invention, the constant current source is preferably a depletion-mode FET of which the source and gate are connected together.

This aspect of the invention does not require a constant voltage source for applying a constant gate-source voltage to a FET to render a constant current source, and a constant current source can be rendered using only a depletion-mode FET.

In another preferred aspect of the invention, the threshold voltage of the depletion-mode FET is in a range where the sign of the temperature coefficient of the drain current of the depletion-mode FET is the same as the sign of the temperature coefficient of the OFF current of the switching FET.

Because the sign of the temperature coefficient of the drain current of the depletion-mode FET is the same as the sign of the temperature coefficient of the OFF current of the switching FET in this aspect of the invention, the balance between the OFF current of the switching FET and the discharge current of the discharge FET can be made more stable relative to changes in the ambient temperature.

Further preferably in an oscillation-stop detection circuit according to another aspect of the invention the discharge FET is composed of two or more series-connected discharge FETs; and the mirror FET is composed of two or more mirror FETs of which the gate and drain of each are connected to common nodes in series, and the gate voltage of each is supplied to a gate of two or more discharge FETs.

When the supply voltage of the oscillation-stop detection circuit becomes high, the effect of channel-length modulation can appear in the drain current of the discharge FET and the discharge current flowing from the capacitor may rise. This aspect of the invention, however, can reduce the drain-source voltage of each of the two or more discharge FETs connected in series and cause each of the discharge FETs to operate in the range where it is difficult for channel-length modulation to occur. The discharge current of the capacitor passing through the discharge FET can therefore be prevented from rising excessively.

Further preferably in an oscillation-stop detection circuit according to another aspect of the invention the oscillation state detection means has a first FET having the same conductive type as the switching FET and the charge voltage of the capacitor applied to the gate thereof, and a second FET having the same conductive type as the discharge FET and the gate voltage that is applied to the discharge FET applied to the gate thereof, connected in series between a high potential power source and a low potential power source, and outputs the oscillation state detection signal from a common node of the first and second FETs.

When the drain current of the switching FET increases (decreases) due to manufacturing tolerances or change in operating conditions such as the ambient temperature, the discharge current flowing from the capacitor through the discharge FET also increases (decreases), and the drain current flowing to the second FET having the same gate voltage as this the discharge FET also increases (decreases). In addition, because the first FET is the same conductive type as the switching FET, the effect of manufacturing tolerances and change in operating conditions such as the ambient temperature appears equally in both the switching FET and the first FET. The logic threshold of the oscillation state detection means composed of the first FET and second FET is therefore a voltage that is stable with respect to manufacturing tolerances and change in operating conditions such as the ambient temperature.

Another aspect of the invention is a semiconductor comprising the oscillation-stop detection circuit described above.

Another aspect of the invention is a timepiece or another electronic device including: an oscillation circuit; a power source; any one of the oscillation-stop detection circuits described above; and a control means that resets a circuit using an output signal of the oscillation circuit and controls increasing a voltage applied to the oscillation circuit from the power source to restart the oscillation circuit when the oscillation-stop detection circuit determines the oscillation circuit stopped oscillating, and cancels resetting the circuit using an output signal of the oscillation circuit and controls lowering the voltage applied from the power source to the oscillation circuit when the oscillation-stop detection circuit determines the oscillation circuit is oscillating.

In a timepiece or electronic device according to this aspect of the invention the electrical characteristics of the oscillation-stop detection circuit are not easily affected by manufacturing tolerances or changes in operating conditions. A timepiece or electronic device that operates stably can therefore be manufactured with a high yield.

### BRIEF DESCRIPTION OF THE DRAWINGS

FIG. 1 is a block diagram showing the configuration of the timekeeping circuit of an electronic device as an example of an oscillation-stop detection circuit according to the invention.

FIG. 2 is a circuit diagram of an oscillation-stop detection circuit according to a first embodiment of the invention.

FIG. 3 is a circuit diagram of an oscillation state detection means in the first embodiment of the invention.

FIG. 4 is a timing chart of the operation of the first embodiment of the invention.

FIG. 5 describes the suitable range of the threshold voltage of a depletion-type P-channel transistor in the first embodiment of the invention.

FIG. 6 is a circuit diagram of an oscillation-stop detection circuit according to a second embodiment of the invention.

FIG. 7 describes the reason for connecting plural N-channel transistors that generate a reference voltage and N-channel transistors as discharge means to the gate of which a reference voltage is applied in series.

FIG. 8 is a circuit diagram of an oscillation state detection means in the oscillation-stop detection circuit according to a third embodiment of the invention.

FIG. 9 is a circuit diagram of an oscillation-stop detection circuit according to a fourth embodiment of the invention.

FIG. 10 is a circuit diagram of an oscillation-stop detection circuit according to a fifth embodiment of the invention.

FIG. 11 is a circuit diagram showing another configuration of the reference voltage generating circuit in the embodiments of the invention.

### DESCRIPTION OF EMBODIMENTS

Preferred embodiments of the present invention are described below with reference to the accompanying figures.

Application of embodiments of the invention

FIG. 1 is a block diagram showing the configuration of a timekeeping circuit in an electronic device as an exemplary application of an oscillation-stop detection circuit according to the invention. In FIG. 1 the oscillation circuit 1 causes a quartz or other type of oscillator to oscillate, and outputs a signal of a specific frequency. The high frequency divider 2 and intermediate-low frequency divider 3 sequentially divide the output signal of the oscillation circuit 1, and output frequency-divided signals of various frequencies.

The control signal generator 4 generates control signals for controlling parts of the timekeeping circuit based on the frequency divided signals obtained from the high frequency divider 2 and intermediate-low frequency divider 3. The motor drive circuit 5 drives a motor for a clock movement, for example, according to a specific control signal output from the control signal generator 4.

The constant voltage generator 6 outputs drive voltage to the oscillation circuit 1 and other circuits in the timekeeping circuit based on the supply voltage applied from a battery not shown. The constant voltage generator 6 can control the level of the output drive voltage.

The oscillation-stop detection circuit 7 according to an embodiment of the invention generates an oscillation state detection signal DET that indicates if the oscillation circuit 1 is oscillating or is stopped based on control signals SA and SB, which the control signal generator 4 generates based on the frequency-divided signal from the high frequency divider 2.

The reset control signal generator 8 sets the reset signal RES to an active level when a oscillation state detection signal DET indicating that the oscillation circuit 1 has stopped oscillating is output, and sets the reset signal RES to an inactive level when an oscillation state detection signal DET indicating that the oscillation circuit 1 is oscillating is output.

The constant voltage generator 6 lowers the drive voltage supplied to the oscillation circuit 1 and high frequency divider 2 to reduce power consumption when the reset signal RES is inactive (that is, the oscillation circuit 1 is oscillating) in this configuration, and switches the drive voltage supplied to the oscillation circuit 1 and high frequency divider 2 to a high voltage to start the oscillation circuit 1 oscillating again when the reset signal RES is active (that is, the oscillation circuit 1 has stopped oscillating).

The intermediate-low frequency divider 3, control signal generator 4, and motor drive circuit 5 operate normally when the reset signal RES is inactive, and reset when the reset signal RES is active. This is because the frequency of the output signal of the oscillation circuit 1 is unstable when a oscillation state detection signal DET indicating that the oscillation circuit 1 has stopped oscillating is output and the reset signal RES is active, and if the intermediate-low frequency divider 3, control signal generator 4, and motor drive circuit 5 continue operating, operation of the entire timekeeping circuit will also be unstable. However, the control signal generator 4 is configured so that the part that generates the control signals SA and SB is not reset. As a result, except for the part that generates control signals SA and SB, the control signal generator 4 is therefore reset when oscillation stops, the circuit part that was not reset is operating when oscillation resumes, and control signals SA and SB can be generated.

Embodiment 1

FIG. 2 is a circuit diagram showing the configuration of an oscillation--stop detection circuit according to a first embodiment of the invention. As shown in FIG. 2, the charge relay circuit 10 includes P-channel transistors 11 and 12 as switching FETs, and a capacitor 13.

The source of P-channel transistor 11 is connected to power source VDD through a high potential supply line, and the source of P-channel transistor 12 is connected to the drain of P-channel transistor 11. Control signals SA and SB are respectively supplied to the gates of P-channel transistors 11 and 12. Control signals SA and SB are generated by the control signal generator 4 shown in FIG. 1 based on the frequency divided signals output from the high frequency divider 2 or intermediate-low frequency divider 3, and are complementary symmetrical signals that when one goes HIGH the other goes LOW, and when one goes LOW the other goes HIGH. The capacitor 13 is inserted between the source of P-channel transistor 12 and the drain of P-channel transistor 11, and the ground line (ground potential VSS), the low potential supply line.

The P-channel transistors 11 and 12 function as switching means for controlling charge movement/interruption in the charge relay circuit 10. More specifically, when control signal SA is LOW and control signal SB is HIGH, P-channel transistor 11 goes ON and P-channel transistor 12 goes OFF, charge moves from power source VDD through P-channel transistor 11 to capacitor 13, and charge movement from the capacitor 13 to the drain of P-channel transistor 12 is interrupted. When control signal SA is HIGH and control signal SB is LOW, P-channel transistor 11 is OFF, P-channel transistor 12 is ON, charge movement from power source VDD through P-channel transistor 11 to capacitor 13 is interrupted, and a charge moves from the capacitor 13 to the drain of P-channel transistor 12.

One side of capacitor 20 is connected to the drain of P-channel transistor 12 in the charge relay circuit 10, and the other side goes to ground. A charge is passed through the charge relay circuit 10 to this capacitor 20.

The inverter 30 is a CMOS (complementary MOS) inverter comprising P-channel transistor 31 and N-channel transistor 32 connected in series between power source VDD and ground VSS as shown in FIG. 3. The inverter 30 is an oscillation state detection means that outputs the oscillation state detection signal DET by digitizing the charge voltage VC of capacitor 20. More specifically, the inverter 30 outputs the oscillation state detection signal DET at a LOW level indicating that the oscillation circuit 1 is oscillating when the charge voltage VC exceeds a logic threshold, and outputs the oscillation state detection signal DET at a HIGH level indicating the oscillation circuit 1 has stopped when the charge voltage VC is below the logic threshold.

A discharge means for discharging the charge stored in the capacitor 20 is rendered in this embodiment of the invention by the reference voltage generator 21 and N-channel transistor 26, which functions as a discharge FET and has the drain and source connected to opposite sides of the capacitor 20.

The reference voltage generator 21 outputs reference voltage VREF to the gate of N-channel transistor 26, and is composed of depletion-mode P-channel transistor 22 and N--channel transistor 23 as a current mirror FET. The source and gate of the depletion-mode P-channel transistor 22 are connected to power source VDD. The drain and gate of N-channel transistor 23 are connected to the drain of depletion-mode P-channel transistor 22, and the source goes to ground. The voltage at the common node between the drain of depletion-mode P-channel transistor 22 and the drain and gate of N-channel transistor 23 is supplied as reference voltage VREF to the gate of N-channel transistor 26.

A gate-source voltage of 0 V is applied to the depletion-mode P-channel transistor 22 in this configuration. A constant current proportional to the square of the threshold voltage flows through depletion--mode P-channel transistor 22 to the N-channel transistor 23. This N-channel transistor 23 and the N-channel transistor 26 render a current mirror. N-channel transistor 26 therefore functions as a constant current source of a current proportional to the square of the threshold voltage of the depletion-mode P-channel transistor 22.

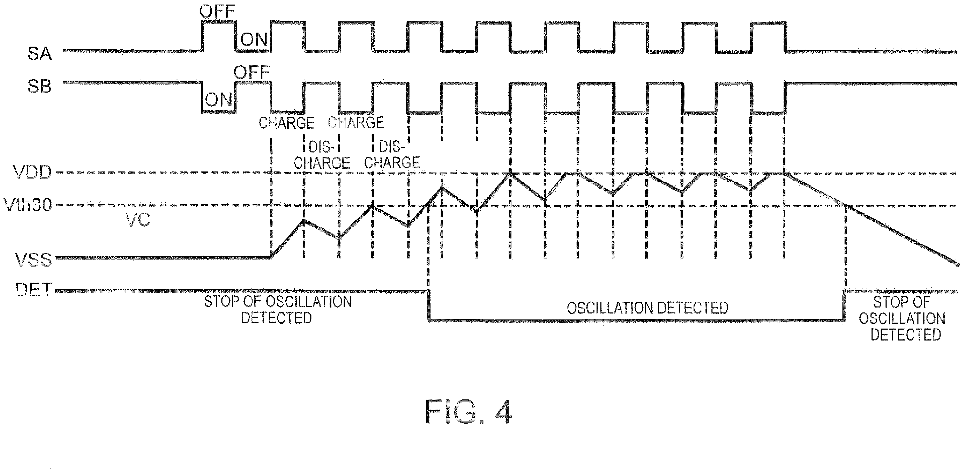

FIG. 4 is a timing chart showing the waveforms at different parts of the oscillation-stop detection circuit according to this embodiment of the invention. This chart shows the waveforms of these parts in the transition from a state in which the oscillation circuit 1 is not oscillating to a state in which the oscillation circuit 1 oscillates, and back again to the state in which the oscillation circuit 1 is not oscillating.

When the oscillation circuit 1 is not oscillating, there is no change in control signals SA and SB, and in this example control signal SA is LOW and control signal SB is HIGH. As a result, either P-channel transistor 11 or 12 (P-channel transistor 11 in the example shown in the figure) is held ON, and the other (P-channel transistor 12 in this example) remains OFF. Because charge is not passed through the charge relay circuit 10 to the capacitor 20 in this state, the charge voltage VC of capacitor 20 is 0 V. As a result, the inverter 30 outputs the oscillation state detection signal DET at a HIGH level indicating that the oscillation circuit has stopped oscillating.

When the oscillation circuit 1 starts oscillating, periodic control signals SA and SB are alternately output LOW. When control signal SA is HIGH and control signal SB is LOW, P-channel transistor 11 of charge relay circuit 10 is OFF and P-channel transistor 12 is ON. The charge to capacitor 13 therefore passes through P-channel transistor 12 to capacitor 20, and the capacitor 20 is charged. During this time the charge current applied through the charge relay circuit 10 to the capacitor 20 exceeds the discharge current of the capacitor 20 flowing through the N-channel transistor 26, and the charge voltage VC of the capacitor 20 rises.

When control signal SA is LOW and control signal SB is HIGH, P-channel transistor 11 of the charge relay circuit 10 is ON and P-channel transistor 12 is OFF, and a charge is not passed through the P-channel transistor 12 to the capacitor 20. As a result, the capacitor 20 charge discharged through the N-channel transistor 26 dominates, and the charge voltage VC of the capacitor 20 drops.

The sizes of the P-channel transistors 11 and 12 and N-channel transistor 26 are therefore determined so that the charge current flowing through the charge relay circuit 10 to the capacitor 20 averaged over one period of the control signals SA and SB is greater than the discharge current flowing through the N-channel transistor 26. As a result, the charge voltage VC of the capacitor 20 rises at a slope approximately proportional to the difference between the former average charge current and the latter discharge current.

When the charge voltage VC of capacitor 20 exceeds the logic threshold Vth30 of the inverter 30, the inverter 30 outputs a LOW oscillation state detection signal DET indicating that the oscillation circuit is oscillating. When the control signals SA and SB then switch, charge current exceeding the discharge current is supplied through the N-channel transistor 26 to the capacitor 20 as a result of the switching operation of the P-channel transistors 11 and 12. Because the charge voltage VC of the capacitor 20 is held at a voltage greater than or equal to the logic threshold Vth30 of the inverter 30, the oscillation state detection signal DET remains LOW.

When the oscillation circuit 1 then stops oscillating and control signals SA and SB stop switching, P-channel transistors 11 and 12 stop switching. As a result, the weak OFF current of P-channel transistor 11 or 12 is supplied to the capacitor 20, and the discharge current exceeding this OFF current flows out from the capacitor 20 through the N-channel transistor 26. The charge voltage VC of the capacitor 20 therefore decreases at a slope proportional to the difference between the discharge current through the N-channel transistor 26 and the OFF current of P-channel transistor 11 or 12. When the charge voltage VC of the capacitor 20 goes below the logic threshold Vth30 of the inverter 30, the inverter 30 outputs a HIGH oscillation state detection signal DET indicating that the oscillation circuit stopped oscillating.

The oscillation-stop detection circuit according to this embodiment of the invention thus operates as described above.

The effect of this embodiment of the invention is described next in comparison with the related art. The conditions for the oscillation-stop detection circuit to operate appropriately are described first.

The OFF current of P-channel transistors 11 and 12, which are switching FETs, must be less than the discharge current of N-channel transistor 26, which is a discharge FET (condition 1). Even if the OFF current flowing to the capacitor 20 through the P-channel transistors 11 and 12 when not switching is greater than the discharge current of the N-channel transistor 26, the OFF current exceeding the discharge current will flow into the capacitor 20 when the oscillation circuit 1 is not oscillating and the control signals SA and SB have stopped. As a result, the charge voltage VC of the capacitor 20 normally exceeds the logic threshold Vth30 of the inverter 30, and an oscillation state detection signal DET indicating that oscillation has stopped will not be output even when the oscillation circuit 1 stops oscillating. To prevent this problem, the OFF current of the switching FETs must be less than the discharge current of the discharge FETs.

Next, the OFF current of the P-channel transistors 11 and 12, which are switching FETs, must not be excessively low relative to the discharge current of the N-channel transistor 26, which is a discharge FET (condition 2). In other words, the discharge current must not be excessively high relative to the OFF current. When the control signals SA and SB stop switching, the charge voltage VC of the capacitor 20 decreases on a slope proportional to the difference between the discharge current of the discharge FET and the OFF current of the switching FETs. Therefore, if condition 2 is not satisfied, such as when voltage chatter occurs in the battery output because the timepiece is dropped, for example, and the control signals SA and SB are interrupted for a short time, the charge voltage VC of the capacitor 20 will go below the logic threshold of the inverter 30 during this short time. A oscillation state detection signal DET indicating that oscillation stopped is output from the inverter 30 in this case even though the oscillation circuit has not actually stopped oscillating, and a system reset occurs. To prevent this problem, the OFF current of the switching FETs must not be extremely low compared to the discharge current of the discharge FET.

The charge current supplied to the capacitor 20 through the switching FETs when switching must be sufficiently greater than the discharge current of the discharge FET (condition 3). When the control signals SA and SB start switching, the charge voltage VC of the capacitor 20 rises on a slope proportional to the time average of the ON current of the switching FETs minus the discharge current of the discharge FET. Therefore, if condition 3 is not satisfied, problems such as the charge voltage VC of the capacitor 20 not rising even when the oscillation circuit 1 starts oscillating and a oscillation state detection signal DET indicating that the oscillation circuit 1 is oscillating not being output, or the charge voltage VC of the capacitor 20 taking too long to rise and the oscillation state detection signal DET indicating that the oscillation circuit 1 is oscillating taking too long to be output, can happen.

In addition, if condition 2 is not satisfied, the oscillation state detection signal DET becomes unstable because the charge voltage VC of the capacitor 20 does not hold a voltage that is sufficiently separated from the logic threshold Vth30 of the inverter 30, which is the oscillation state detection means.

Yet further, if the charge voltage VC of the capacitor 20 is close to the logic threshold Vth30 of the oscillation state detection means, through-current flowing through the CMOS inverter increases and power consumption increases when a CMOS inverter is used for the oscillation state detection means as shown in FIG. 3.

To prevent such problems, the charge current supplied to the capacitor 20 through the switching FETs must be sufficiently greater than the discharge current of the discharge FET.

To achieve an oscillation-stop detection circuit that satisfies these three conditions using the technology taught in JP-A-2007-81514 and Japan Patent No. 4459663 requires strict process control. The reason for this is described below.

The oscillation-stop detection circuit taught in JP-A-2007-81514 uses a resistor as the discharge element for discharging the charge current of the capacitor 20. To minimize the power consumption of the oscillation-stop detection circuit, the resistance of the discharge resistor must be sufficiently high. When a discharge resistor with such high resistance is achieved using a diffused resistor, for example, the area occupied by the discharge resistor in the chip increases, and chips having the oscillation-stop detection circuit become expensive. The discharge resistor could be rendered using an intrinsic semiconductor with high relative resistance such as polycrystalline silicon, but the resistance of an intrinsic semiconductor has a high manufacturing tolerance.

The manufacturing process for producing a field effect transistor and the manufacturing process for producing a discharge resistor (a diffused resistor or an intrinsic semiconductor resistor) in the oscillation-stop detection circuit described in JP-A-2007-81514 are also not the same. As a result, there is no correlation between the electrical characteristics of a field effect transistor and the electrical characteristics of a discharge resistor even if they are on the same chip, and even if the OFF current and ON current of the switching FETs deviate to the high side, there is no assurance that the discharge current of the discharge resistor will also deviate to the high side. Depending on the manufacturing tolerance, the oscillation-stop detection circuit may not be able to satisfy the above conditions 1 to 3.

The oscillation-stop detection circuit taught in Japan Patent No. 4459663 uses a FET as the discharge device. However, the oscillation-stop detection circuit taught in Japan Patent No. 4459663 uses an N-channel transistor as the switching FETs, and a P-channel transistor as the discharge FET (see capacitor N-channel transistor 13 and P-channel transistor 15 in FIG. 3 of Japan Patent No. 4459663). Because the manufacturing process of the N-channel transistor and the manufacturing process of the P-channel transistor are not the same, the discharge current flowing through the P-channel transistor used as the discharge FET will not necessarily deviate to the high side even if the OFF current and ON current of the N-channel transistor used as the switching FETs range on the high side.

The regulator in the technology described in Japan Patent No. 4459663 generates a reference voltage supplied to the gate of the P-channel transistor used as the discharge FET based on the voltage drop of an internal resistor. This resistor in the regulator is manufactured in a separate manufacturing process than those of the N-channel transistor and P-channel transistor in the oscillation-stop detection circuit.

With the technology taught in Japan Patent No. 4459663, therefore, the amount of discharge current flowing through the P-channel transistor is affected not only by the manufacturing tolerance of the electrical characteristics of the P-channel transistor but also by the manufacturing tolerance of the resistor in the regulator, and there is no correlation between the electrical characteristics of the resistor in the regulator and the electrical characteristics of the P-channel transistor. It is therefore even more difficult to satisfy conditions 1 to 3 described above with the technology taught in Japan Patent No. 4459663 than the technology taught in JP-A-2007-81514.

The discharge current of the discharge FET also depends on the reference voltage output by the regulator to drive the oscillation circuit in the device taught in Japan Patent No. 4459663. The optimum reference voltage for operating the oscillation circuit with the lowest possible power consumption, and the reference voltage for optimizing the discharge current of the oscillation-stop detection circuit, therefore often differ, and optimizing the characteristics of both the oscillation circuit and the oscillation-stop detection circuit using a common reference voltage is difficult.

In contrast, this embodiment of the invention uses P-channel transistors 11 and 12, which are switching FETs, and a normally-conducting depletion-mode P-channel transistor 22, as the constant current source of the reference voltage generator 21. The N-channel transistor 23, which is a mirror FET to which the drain current of the depletion-mode P-channel transistor 22 flows, and the N-channel transistor 26, which is a discharge FET, form a current mirror.

When the OFF current or ON current supplied to the capacitor 20 through the switching FETs increases (decreases) due to manufacturing tolerances or change in ambient temperature or other operating condition, the discharge current flowing from the capacitor 20 through the discharge FET also increases (decreases).

Therefore, if the threshold voltage of the transistors and the size of the transistors rendering the oscillation-stop detection circuit are determined so that the OFF current and ON current of the switching FETs and the discharge current of the discharge FET satisfy conditions 1 to 3 above, conditions 1 to 3 can be satisfied and the oscillation-stop detection circuit can be made to operate normally even if manufacturing variations occur or the operating conditions change.

The reference voltage VREF supplied to the gate of N-channel transistor 26, which is a discharge FET, is generated by the reference voltage generator 21 in the oscillation-stop detection circuit in this embodiment of the invention and not by the constant voltage generator 6 that supplies drive voltage to the oscillation circuit 1. The discharge current of the discharge FET can therefore be optimized independently to optimization of the oscillation circuit 1 drive voltage.

When the oscillation-stop detection circuit according to this embodiment of the invention is used in an environment where the ambient temperature changes, the sign of the temperature coefficient of the OFF current of the switching P-channel transistors 11 and 12, and the sign of the temperature coefficient of the drain current of the depletion-mode P-channel transistor 22 that determines the discharge current of the discharge FET, are preferably the same. The target value of the threshold voltage Vth of the depletion-mode P-channel transistor 22 is therefore set in a suitable range.

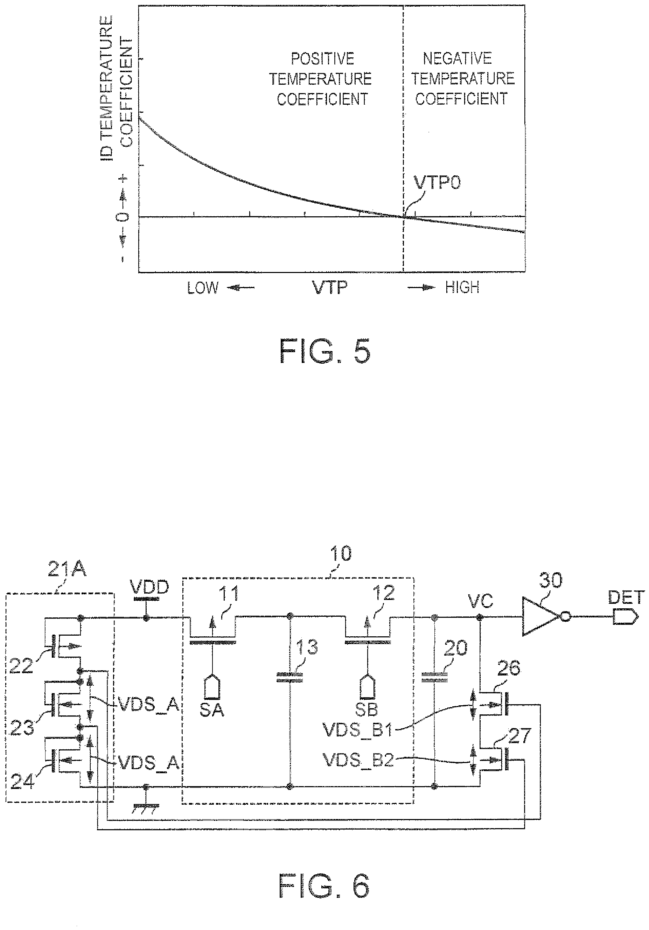

FIG. 5 describes the suitable range of the threshold voltage VTP of the depletion-mode P-channel transistor 22. The x-axis in FIG. 5 shows the threshold voltage VTP of the depletion-mode P-channel transistor 22, and the y-axis shows the rate of change in the drain current ID when the ambient temperature is 75°C to the drain current ID of the depletion-mode P-channel transistor 22 when the ambient temperature is 25°C when the reference voltage generator 21 is configured with a depletion-mode P-channel transistor 22 as shown in FIG. 2.

When the ambient temperature rises, the FET threshold voltage drops, carrier mobility drops, and current gain β drops. The OFF current of the P-channel transistors 11 and 12, which are switching FETs, is dominated by change in the former threshold value, and increases as the ambient temperature rises. More specifically, the temperature coefficient of the OFF current of the P-channel transistors 11 and 12 is positive.

Both the drop in the threshold voltage resulting from an increase in the ambient temperature and the drop in carrier mobility resulting from an increase in ambient temperature dominate the drain current ID of the depletion-mode P-channel transistor 22, and which of these factors is stronger depends on the threshold voltage VTP of the depletion-mode P-channel transistor 22. As shown in FIG. 5, when the threshold voltage VTP is high, the drop in carrier mobility resulting from an increase in ambient temperature contributes greatly to the drain current ID, and the temperature coefficient of the drain current ID becomes negative. However, if the threshold voltage VTP is lower than a threshold voltage VTP0, the drop in threshold voltage VTP contributes greatly to the drain current ID, and the temperature coefficient of the drain current ID changes from negative to positive.

The target threshold voltage VTP of the depletion-mode P-channel transistor 22 when manufacturing the oscillation-stop detection circuit is therefore a threshold voltage lower than the threshold voltage VTP0 at which the temperature coefficient of the drain current ID changes from negative to positive (in the range where the slope of the temperature coefficient of the drain current ID is positive).

The same relationship can therefore be maintained between the OFF current of the P-channel transistors 11 and 12, which are switching FETs, and the drain current of the depletion-mode P-channel transistor 22 that determines the discharge current of the discharge FET, in the system operating temperature range, and the oscillation-stop detection circuit can be made to operate stably.

Embodiment 2

FIG. 6 is a circuit diagram showing the configuration of an oscillation-stop detection circuit according to a second embodiment of the invention. When an oscillation-stop detection circuit is used in an electronic device with a variable supply voltage, such as an electronic device powered by a storage battery, the discharge current of the discharge FET can rise excessively due to a rise in the supply voltage.

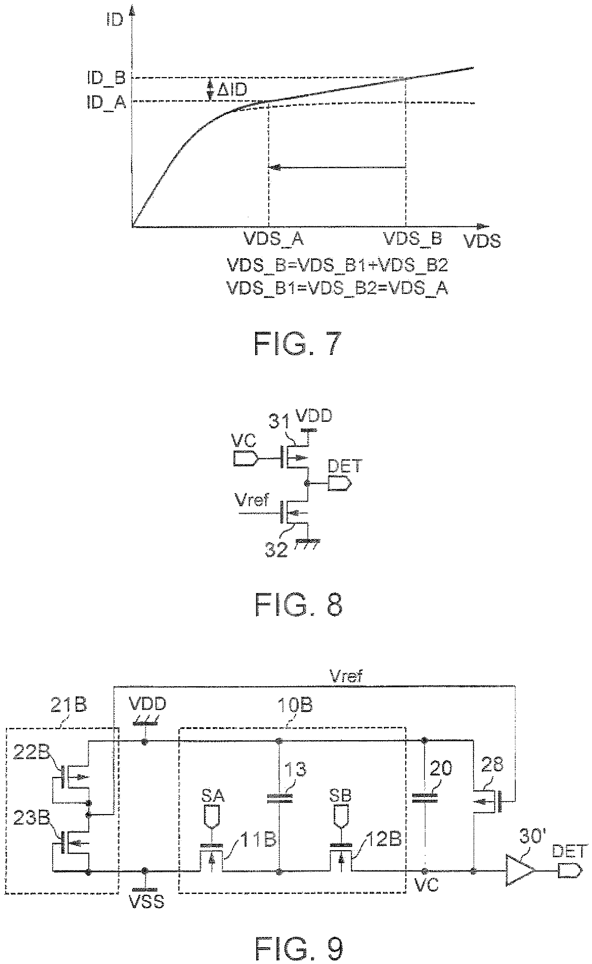

FIG. 7 shows the drain current characteristic of the discharge FET in the first embodiment of the invention (FIG. 2). The x-axis in FIG. 7 shows the drain-source voltage VDS (that is, the charge voltage VC of the capacitor 20) of the N-channel transistor 26, which is a discharge FET, and the y-axis shows the drain current ID of the N-channel transistor 26.

Ideally, the N-channel transistor 26 drain current ID is saturated as indicated by the dotted line as the drain-source voltage VDS increases. However, when the drain-source voltage VDS rises, the thickness of the depletion layer formed at the boundary between the drain of the N-channel transistor 26 and the p-type semiconductor substrate increases, and channel-length modulation (CLM) results in the effective channel length of the N-channel transistor 26 becoming shorter. As a result, comparing the drain current ID_A when the drain-source voltage VDS of N-channel transistor 26 is voltage VDS_A, and the drain current ID_B when drain-source voltage VDS is voltage VDS_B, which is higher than voltage VDS_A, in the saturation range shows that drain current ID_B is ⊗ID greater than drain current ID_A.

When the oscillation circuit 1 is oscillating, the capacitor 20 is charged to a level near supply voltage VDD. Therefore, if the oscillation-stop detection circuit operates when supply voltage VDD is high, the drain-source voltage VDS of N-channel transistor 26 becomes high, and excess current flows to the N-channel transistor 26. If the discharge current flowing through the N-channel transistor 26 rises, satisfying condition 2 or condition 3 described above may not be possible.

This embodiment of the invention modifies the first embodiment described above to prevent such an excessive discharge current from flowing to the discharge FET when the supply voltage VDD is high. In the oscillation-stop detection circuit according to this embodiment of the invention (FIG. 6), two N-channel transistors 26 and 27 connected in series as a discharge FET are parallel connected to the capacitor 20. The reference voltage generator 21A has two N-channel transistors 23 and 24 connected in series with their gates and drains connected in common as a mirror FET. These N-channel transistors 23 and 24 supply their gate voltages to the gates to the gates of the N-channel transistors 26 and 27, which are discharge FETs.

This configuration can set the drain-source voltage of the N-channel transistor 23 and the drain-source voltage of the N-channel transistor 24 to a common voltage VDS_A having a minimal channel-length modulation effect. The gate voltage VDS_A of N-channel transistor 24 is supplied to the gate of N-channel transistor 27, and the gate voltage 2VDS_A of N-channel transistor 23 is supplied to the gate of N-channel transistor 26. Therefore, when the charge voltage VC of the capacitor 20 is voltage 2VDS-A, both drain-source voltage VDS_B1 of N-channel transistor 26 and drain-source voltage VDS_B2 of N-channel transistor 27 are voltage VDS_A when the charge voltage VC of the capacitor 20 is voltage 2VDS_A. When the charge voltage VC of capacitor 20 is voltage 2VDS_A or greater, drain-source voltage VDS_B1 of N-channel transistor 26 and drain-source voltage VDS_B2 of N-channel transistor 27 are substantially the same voltage. The N-channel transistors 26 and 27 operating as the discharge FET therefore do not passes excessive discharge current because they operate when the drain-source voltage is not excessively high and there is little channel-length modulation.

Note that while two mirror FETs and discharge FETs are used in the configuration shown in FIG. 6, the number can be increased according to the increase in the supply voltage VDD when the supply voltage VDD is higher.

Embodiment 3

FIG. 8 is a circuit diagram showing the configuration of an oscillation state detection means in an oscillation-stop detection circuit according to a third embodiment of the invention. The oscillation state detection means in the first embodiment described above is a CMOS inverter 30 composed of P-channel transistor 31 and N-channel transistor 32, and the charge voltage VC of the capacitor 20 is applied to this inverter 30. Because the P-channel transistor 31 and N-channel transistor 32 are manufactured in separate processes, there is no correlation between deviation in the characteristics of the P-channel transistor 31 and deviation in the characteristics of the N-channel transistor 32. The logic threshold of the inverter 30 can therefore vary due to variation in the characteristics of the P-channel transistor 31 and variations in the characteristics of the N-channel transistor 32. When the logic threshold of the inverter 30 fluctuates, the time from when the oscillation circuit starts oscillating until the oscillation state detection signal inverts increases, or the oscillation state detection signal can invert easily when control signal SA, SB is interrupted. This embodiment of the invention solves this problem.

In the oscillation state detection means in this embodiment of the invention, the capacitor 20 charge voltage VC is applied only to the gate of P-channel transistor 31, and the reference voltage VREF generated by the N-channel transistor 23 of the reference voltage generator 21 (see FIG. 2) is applied to the gate of N-channel transistor 32, as shown in FIG. 8. The oscillation state detection signal DET is output from a common node between the drains of the P-channel transistor 31 and N-channel transistor 32.

When something causes the drain current of the P-channel transistor 31 to increase (decrease) due to manufacturing tolerances or change in operating conditions, the drain current of the N-channel transistor 32, which is proportional to the drain current of the depletion-mode P-channel transistor 22, also increases (decreases). The logic threshold of the oscillation state detection means in this embodiment of the invention is therefore stable with respect to manufacturing tolerances and operating conditions, and the foregoing problems do not occur.

Embodiment 4

FIG. 9 is a circuit diagram showing the configuration of the oscillation-stop detection circuit according to a fourth embodiment of the invention. P-channel transistors 11 and 12 are used as switching FETs in the charge relay circuit 10 of the first embodiment described above (FIG. 2). The charge relay circuit 10B in this embodiment of the invention, however, uses N-chancel transistors 11B and 12B as switching FETs.

In addition, N-channel transistor 26 is used as a discharge FET in the foregoing first embodiment. In this embodiment of the invention, however, a P-channel transistor 28 parallel connected to the capacitor 20 is used as the discharge FET.

The reference voltage generator 21 is composed of depletion-mode P-channel transistor 22 and depletion-mode N-channel transistor 23, and N-channel transistor 23 together with N-channel transistor 26, which is a discharge FET, render a current mirror in the first embodiment. In this embodiment, however, the reference voltage generator 21B is rendered by depletion-mode N-channel transistor 23B and P-channel transistor 22B, and P-channel transistor 22B together with P-channel transistor 28, which is a discharge FET, render a current mirror.

Yet further, a non-inverting buffer 30' composed of two CMOS inverters, for example, is used as the oscillation state detection means in this embodiment of the invention.

In this embodiment of the invention, current proportional to the drain current of depletion-mode N-channel transistor 23B flows to the P-channel transistor 28, which is a discharge FET. As a result, when the drain current of N-channel transistors 11B and 12B, which are switching FETs, increases (decreases), the discharge current flowing to P-channel transistor 28 also increases (decreases). This embodiment of the invention therefore has the same effect as the first embodiment described above.

Embodiment 5

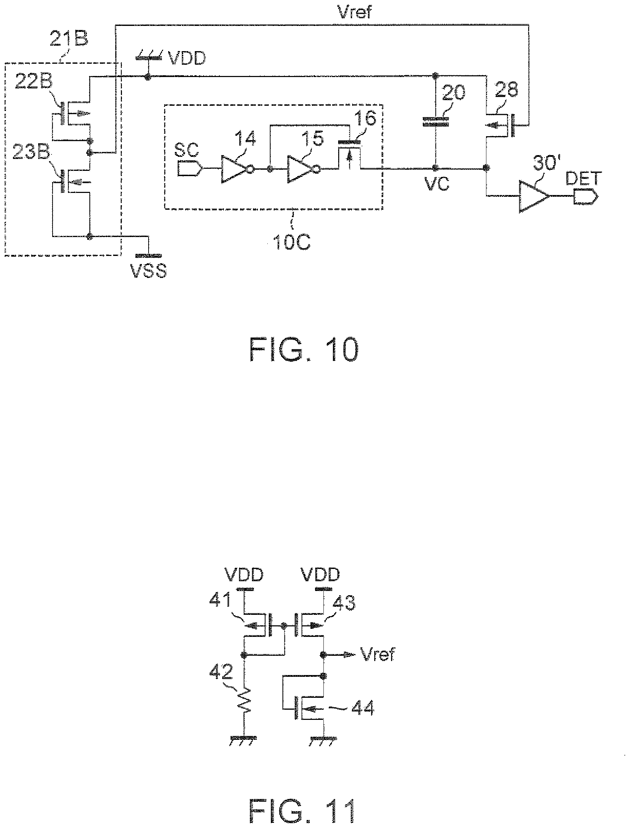

FIG. 10 is a circuit diagram of the oscillation-stop detection circuit according to a fifth embodiment of the invention. The oscillation-stop detection circuit in this embodiment replaces the charge relay circuit 10B of the fourth embodiment with charge relay circuit 10C.

The inverter 14 in this charge relay circuit 10C outputs inverted control signal SC. Similarly to control signals SA and SB in the first embodiment, this control signal SC is produced from the output signal of the oscillation circuit.

Inverter 15 inverts and outputs the output signal from inverter 14. N-channel transistor 16 is a transistor that functions as a switching FET with the source connected to the output terminal of 15, the output signal of inverter 14 applied to the gate, and the drain connected to a common node between one terminal of capacitor 20 and the drain of P-channel transistor 28.

When control signal SC is LOW in this configuration, the output signal of inverter 14 goes HIGH, N-channel transistor 16 turns ON, and the output signal of 15 goes LOW. As a result, capacitor 20 is charged by the drain current of N-channel transistor 16. When control signal SC goes HIGH, the output signal of inverter 14 goes LOW, and N-channel transistor 16 turns OFF. N-channel transistor 16, which is a switching FET, thus switches ON/OFF according to the control signal SC, and charge is passed to the capacitor 20 through the N-channel transistor 16.

The configuration of the reference voltage generator 21B, capacitor 20, P-channel transistor 28, and non-inverting buffer 30' parts are identical to the fourth embodiment described above. This embodiment has the same effect as the fourth embodiment.

Other embodiments

First to fifth embodiments of the invention are described above, but the invention is not limited thereto and can be varied in many ways such as described below.

(1) The oscillation-stop detection circuit is applied to a timepiece in the first embodiment. The oscillation-stop detection circuit according to the invention is not so limited, however, and can be applied to many electronic devices having an oscillation circuit other than timepieces, including cellular phones and personal digital assistants (PDA).

(2) Depletion-mode transistors of which the gates and sources are connected together are used as the constant current source that supplies output current to the mirror FET in the foregoing embodiments. However, the constant current source is not limited to this configuration. For example, when the switching FET is a P-channel transistor, the constant current source uses a conductive P-channel transistor, the output current of this constant current source is supplied to the mirror FET, and the gate voltage of the mirror FET is supplied as reference voltage VREF to the gate of the discharge FET.

FIG. 11 is a circuit diagram showing the configuration of a reference voltage generator including this type of constant current source. In FIG. 11 the sources of P-channel transistors 41 and 43 are connected to power source VDD, and the gates are connected to the drain of P-channel transistor 41. A resistor 42 is inserted between the drain of P-channel transistor 41 and ground. The drain of P-channel transistor 43 is connected to the gate and drain of N-channel transistor 44, which is a mirror FET, and the source of N-channel transistor 44 goes to ground.

The circuit composed of P-channel transistors 41 and 43 and N-channel transistor 44 renders a constant current source in this reference voltage generator, and the output current of this constant current source is supplied to N-channel transistor 44, which is a mirror FET.

A discharge current proportional to the drain current of P-channel transistor 43 flows to the discharge FET in this configuration. As a result, when the drain current of the P-channel transistors, which are switching FETs, increases (decreases), the discharge current also increases (decreases). This configuration therefore achieves the same effect as the embodiments described above.

The oscillation-stop detection circuit according to the embodiments and variations described above may be rendered as all or part of a semiconductor device such as an integrated circuit device.

## Claims

1. An oscillation-stop detection circuit comprising:
a switching field-effect transistor (FET) that passes a charge by switching according to a control signal generated from an output signal of an oscillation circuit;
a capacitor that is charged by charge passed from the switching FET;
a discharge means that discharges capacitor charge; and
an oscillation state detection means that digitizes the charge voltage of the capacitor and outputs an oscillation state detection signal that indicates if the oscillation circuit is oscillating or is stopped;
wherein the discharge means includes
a discharge FET that discharges charge stored in the capacitor,
a mirror FET that with the discharge FET renders a current mirror, and
a constant current source composed of a field-effect transistor that is the same conductive type as the switching FET, and supplies drain current to a common coupling node of the gate and drain of the mirror FET.

2. The oscillation-stop detection circuit described in claim 1, wherein:
the constant current source is a depletion-mode FET of which the source and gate are connected together.

3. The oscillation-stop detection circuit described in claim 2, wherein:
the threshold voltage of the depletion-mode FET is in a range where the sign of the temperature coefficient of the drain current of the depletion-mode FET is the same as the sign of the temperature coefficient of the OFF current of the switching FET.

4. The oscillation-stop detection circuit described according to any one of claims 1 to 3, wherein:
the discharge FET is composed of two or more series-connected discharge FETs; and
the mirror FET is composed of two or more mirror FETs of which the gate and drain of each are connected to common nodes in series, and the gate voltage of each is supplied to a gate of two or more discharge FETs.

5. The oscillation-stop detection circuit described according to any one of claims 1 to 4, wherein:
the oscillation state detection means has a first FET having the same conductive type as the switching FET and the charge voltage of the capacitor applied to the gate thereof, and a second FET having the same conductive type as the discharge FET and the gate voltage that is applied to the discharge FET applied to the gate thereof, connected in series between a high potential power source and a low potential power source, and outputs the oscillation state detection signal from a common node of the first and second FETs.

6. A semiconductor device comprising the oscillation-stop detection circuit described according to any one of claims 1 to 5.

7. A timepiece comprising:
an oscillation circuit;
a power source;
the oscillation-stop detection circuit described in any of claims 1 to 5; and
a control means that resets a circuit using an output signal of the oscillation circuit and controls increasing a voltage applied to the oscillation circuit from the power source to restart the oscillation circuit when the oscillation-stop detection circuit determines the oscillation circuit stopped oscillating, and
cancels resetting the circuit using an output signal of the oscillation circuit and controls lowering the voltage applied from the power source to the oscillation circuit when the oscillation-stop detection circuit determines the oscillation circuit is oscillating.

8. An electronic device comprising:
an oscillation circuit;
a power source;
the oscillation-stop detection circuit described in any of claims 1 to 5; and
a control means that resets a circuit using an output signal of the oscillation circuit and controls increasing a voltage applied to the oscillation circuit from the power source to restart the oscillation circuit when the oscillation-stop detection circuit determines the oscillation circuit stopped oscillating, and
cancels resetting the circuit using an output signal of the oscillation circuit and controls lowering the voltage applied from the power source to the oscillation circuit when the oscillation-stop detection circuit determines the oscillation circuit is oscillating.
